Europäisches Patentamt

European Patent Office

Office européen des brevets

(19)

(11) Numéro de publication : **0 298 849 B1**

(12) **FASCICULE DE BREVET EUROPEEN**

(45) Date de publication du fascicule du brevet :
**18.03.92 Bulletin 92/12**

(51) Int. Cl.⁵ : **G01R 33/54**

(21) Numéro de dépôt : **88401718.7**

(22) Date de dépôt : **01.07.88**

(54) **Procédé de reconstruction d'images acquises par experimentation tridimensionnelle notamment en RMN.**

Le dossier contient des informations
techniques présentées postérieurement au
dépôt de la demande et ne figurant pas dans le
présent fascicule.

(30) Priorité : **10.07.87 FR 8709814**

(43) Date de publication de la demande :
**11.01.89 Bulletin 89/02**

(45) Mention de la délivrance du brevet :
**18.03.92 Bulletin 92/12**

(84) Etats contractants désignés :
**DE ES GB IT NL**

(56) Documents cités :
**EP-A- 0 091 008**
**EP-A- 0 100 183**

(73) Titulaire : **GENERAL ELECTRIC CGR S.A.**
**13, Square Max-Hymans**
**F-75015 Paris (FR)**

(72) Inventeur : **Barjhoux, Yves**
**Résidence les Grandes Coudraies E 24**
**F-91190 Gif Sur Yvette (FR)**

(74) Mandataire : **Ballot, Paul Denis Jacques et al**
**Cabinet Ballot-Schmit 7, rue le Sueur**
**F-75116 Paris (FR)**

## Description

La présente invention a pour objet un procédé de reconstruction d'images acquises par expérimentation tridimensionnelle notamment en résonance magnétique nucléaire, RMN. Le procédé de l'invention est en particulier aussi applicable à la spectrométrie par RMN ou à la spectrométrie par rayons X. Il peut être transposé aux calculs de reconstruction d'image utilisés en tomodensitométrie. Parmi tous les procédés de reconstruction envisagés, le procédé de reconstruction dit 3DFT est particulièrement visé. Les procédés d'imagerie par acquisition tridimensionnelle, dits procédés d'imagerie 3D, présentent de nombreux avantages par rapport aux procédés d'acquisition bidimensionnelle, dits 2D avec sélection de coupe dans les corps étudiés. Notamment ils permettent de proposer des coupes fines, jointives, et dont le profil n'est pas distordu par des étapes supplémentaires de procédé imposées pour définir cette coupe. Ils présentent cependant par rapport aux procédés 2D l'inconvénient de nécessiter des durées d'acquisition et de reconstruction d'images prohibitives.

Les récents perfectionnements des méthodes d'excitation des moments magnétiques des protons, à précession libre en régime d'équilibre dit aussi SSFP (Steady State Free Precession) dans la littérature Anglo-Saxonne, ont considérablement réduit les durées d'acquisition 3D. Le temps de présentation des images ne dépend plus alors essentiellement que de la durée de reconstruction. Typiquement il est connu de représenter les images avec des résolutions sensiblement égales suivant deux axes de référence de l'image. Par contre, pour un axe orienté perpendiculairement aux images, selon l'empilement de ces images, soit on se contente d'une résolution moins bonne (en définitive on choisit des tranches relativement épaisses : par exemple 1 cm), soit on limite le volume dans lequel on veut réaliser ces images. Si on suppose par exemple que le corps d'un patient est allongé dans une machine de RMN selon un axe Z, et qu'on veut faire dans ce corps des images de coupes transversales avec des résolutions dans chaque image de, par exemple, 256 x 256 éléments d'images (pixel), on peut se contenter, par exemple, d'une représentation de seulement huit images superposées selon l'axe Z. Cet exemple numérique type sera retenu dans la suite de la présentation de l'invention parce qu'il permet de bien fixer les idées. Bien entendu l'enseignement de l'invention ne peut être considéré comme cantonné à cet exemple numérique.

La mixe en oeuvre d'un procédé d'imagerie de type 3DFT nécessite l'application de séquences d'excitation-mesure comportant d'une part une excitation électromagnétique radiofréquence du corps à examiner et la mesure d'un signal de RMN de désexcitation qui en résulte; et d'autre part l'application d'impulsions de gradients de champ magnétique supplémentaires (superposés au champ magnétique principal de la machine) dont les orientations des gradients sont prédeterminées par rapport aux orientations des images des coupes à obtenir (transversales içi). On sait que pendant la mesure du signal de RMN un gradient dit de lecture est appliqué selon un tel axe prédéterminé dit axe de lecture. En général l'axe de lecture est appelé axe X. Au cours de l'expérimentation 3D, les gradients de champ appliqués sur des axes dits de codage de phase (Y) et de sélection de coupe (Z) prennent des valeurs différentes d'une séquence à l'autre. Par exemple il est connu d'imposer le gradient de sélection de coupe à une valeur donnée et pendant une durée donnée au cours de chaque séquence d'une première série de séquences, tandis que la valeur du gradient de codage de phase évolue pas à pas au cours de cette première série de séquences. Lorsque cette première série de séquences est acquise, on incrémente la valeur du gradient de sélection de coupe et on réitère toute la série de séquences. Au cours des séquences de cette autre série, le gradient de codage de phase prend à nouveau la même série de valeurs que pour la première série de séquences. On recommence ces séries de séquences aussi souvent de fois qu'on veut obtenir d'images comptées dans le sens de l'empilement sur l'axe (Z). A l'issue de chaque série de séquences on calcule par transformation de Fourier bidimensionnelle des contributions aux images définitives. Ces contributions sont ainsi acquises au cours de chacune de ces séries de séquences. Lorsque toutes les contributions aux images on été calculées, on calcule les éléments d'images de toutes les images par transformation de Fourier à partir de ces contributions aux images. Typiquement chaque image de contribution est définie sur un espace de 256 x 256 points. Les calculs des images définitives nécessitent alors, dans l'exemple, l'exécution de 8 x 256 x 256 = 524 288 transformées de Fourier monodimensionnelles (ou de 256 x 256 = 65536 transformations de Fourier) dont le nombre de points de calcul dans chacune est faible : il correspond au faible nombre (huit) des séries de séquences, qui correspond lui-même au faible nombre des images qu'on cherche à représenter dans l'empilement.

Cette manière d'agir présente de nombreux inconvénients. En particulier l'exécution d'un nombre très important de transformées de Fourier, à un faible nombre de points de calcul, est mal adaptée aux processeurs vectoriels utilisés. En effet ces processeurs son normalement optimisés pour effectuer des nombres de points de calcul plus importants. Dans la pratique on arrive ainsi à une durée de reconstruction d'image de l'ordre de 12 minutes dans l'exemple précité. D'autre part, le mode d'acquisition est tel que pendant cette durée de reconstruction aucun résultat intermédiaire n'est disponible : toutes les images sont calculées et disponibles en même temps. De sorte que ce temps d'attente ne peut pas être utilisé à l'interprétation d'images qui seraient présentées au fur et à mesure. En outre compte tenu du nombre de données à traiter simultanément, les problèmes d'adressage rencontrés pour mettre en oeuvre ces procédés de reconstruction sont importants.

Enfin il n'est pas toujours nécessaire de choisir dans l'image une même résolution selon les deux axes. Par exemple on peut décider de produire des images de 256 x 128 pixels. On se heurte alors à une difficulté supplémentaire. En effet, cette diminution de résolution selon un des axes de l'image, qui entraine une diminution par deux de la durée d'acquisition des mesures, est contrebalancée par l'inexistence de programmes standards dans les processeurs vectoriels utilisés pour traiter en reconstruction par transformée de Fourier bidimensionnelle des ensembles non symétriques. Ne disposant pas de programme préenregistré qui fonctionne selon un algorithme rapide, il est nécessaire de programmer un algorithme spécifique. Cet algorithme spécifique ne peut pas être aussi bien adapté à la machine que l'algorithme rapide pour lequel la machine elle-même a été conçue. Il en résulte que le gain de temps attendu n'est pas atteint.

L'invention a pour objet de remédier aux inconvénients cités en modifiant l'organisation de l'acquisition des séquences ainsi que l'organisation du calcul de reconstruction des images. Dans ce calcul on tire partie du fait que selon une des dimensions d'acquisition la résolution d'image, ou le nombre des images, est faible. En pratique au lieu d'effectuer en premier lieu des transformées de Fourier bidimensionnelles symétriques (par exemple à 256 par 256), on effectue des transformées de Fourier asymétriques ( par exemple 8 x 256). Cependant les processeurs vectoriels sont en général conçus pour travailler avec une mémoire rapide, de faible capacité, et une mémoire plus lente de grande capacité. Dans l'invention on a remarqué que le calcul de transformées de Fourier bidimensionnelles fortement asymétriques permettait, en utilisant tout le volume utile de la mémoire rapide, d'utiliser les processeurs vectoriels au maximum de leur vitesse de travail. Ultérieurement une troisième transtormée de Fourier monodimensionnelle est effectuée avec un nombre de pas de calcul important (256) qui correspond lui aussi à une utilisation maximale de la puissance de calcul du processeur vectoriel. Il en résulte qu'en taisant travailler, à tout instant, le processeur au maximum de sa capacité on arrive à produire les images plus vite que si on le pénalise par un trop grand nombre d'opérations notablement trop simples pour sa puissance. On évite un grand nombre d'aller retour entre le processeur et la mémoire lente.

L'invention a donc pour objet un procédé de reconstruction dont les données d'images sont acquises à partir d'une expérimentation de RMN, procédé du type 3DFT pour lequel on s'impose que la résolution de M points de l'image selon un (Z) des axes de l'image soit inférieure aux résolutions de N et P points de l'image selon les deux autres axes (Y,X) de cette image, caractérisé en ce qu'il comporte dans l'ordre, à partir des données d'image, un premier calcul de N x M x P transformées de Fourier à P points de calcul, suivi d'un deuxième calcul de N x M x P transformées de Fourier à M points de calcul, et suivi d'un troisième calcul de N x M x P transformées de Fourier à N points de calcul l'image reconstruite se déduisant du résultat du troisième calcul.

Une résolution de Q points d'image, au sens de l'invention, est équivalente à une résolution vraie de Rmm, ou R est égal à la dimension L d'une image étudiée divisée par le nombre Q des points présentés selon cette dimension, Q étant ainsi équivalent à R, pour L donné.

L'invention sera mieux comprise à la lecture de la description qui suit et à l'examen des figures qui l'accompagnent. Celles ci ne sont données qu'à titre indicatif et nullement limitatif de l'invention les figures montrent :
– figure 1 : une machine de RMN utilisable pour la mise en oeuvre du procédé selon l'invention;
– figure 2a à 2d : des diagrammes temporels de signaux de gradients de champs magnétiques de codage utilisés dans le procédé selon l'invention;
– figure 3a et 3d : l'allure des répartitions temporelles des différentes phases du procédé selon l'invention.

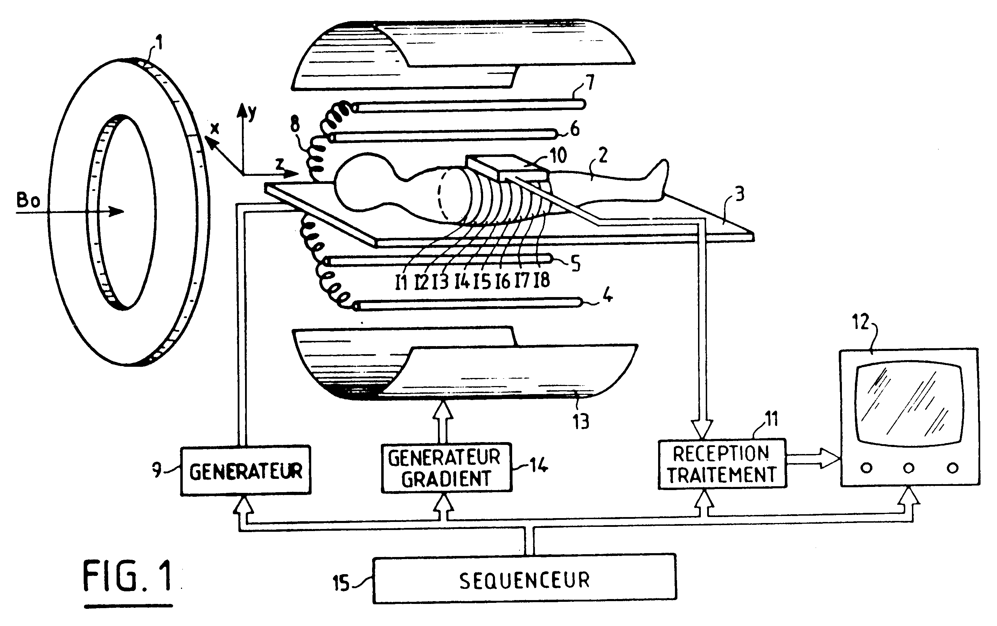

La figure 1 montre une machine de RMN pour la mise en oeuvre du procédé selon l'invention. Cette machine comprend essentiellement un aimant symbolisé par une bobine 1 pour produire un champ homogène intense $B_0$ dans une zone d'examen. Cette zone d'examen se situe à l'endroit où est placé le corps 2 d'un patient à examiner au dessus d'un plateau 3. Soumis à cette influence magnétique le corps 2 est de plus soumis à une excitation électromagnétique radiofréquence induite par une antenne, par exemple à barres rayonnantes telles que 4 à 7, alimentée par un circuit oscillant 8 à partir d'un générateur 9 d'excitation radiofréquence. Une antenne 10 sert à prélever le signal de désexcitation des moments magnétiques des protons du corps. Dans certains cas l'antenne 10 peut être confondue avec l'antenne d'excitation. Le signal détecté est acheminé sur un circuit 11 de réception et de traitement en vue de la représentaiton des images des coupes $I_1$ à $I_8$ sur un écran de visualisation 12. De manière à mettre en oeuvre le procédé d'imagerie 3DFT la machine comporte en outre des bobines de gradient symbolisées par les bobines 13 alimentées par un générateur 14 d'impulsions de gradient. L'ensemble de ces moyens fonctionne sous le contrôle d'un séquenceur 15. La figure 1 montre encore des axes XYZ. On remarque que les images seront developpées selon les axes X et Y et empilées les unes sur les autres selon l'axe Z. Les fonctionnalités de ces axes peuvent par ailleurs être interverties ou même combinées de manière à produire des images d'orientation quelconque.

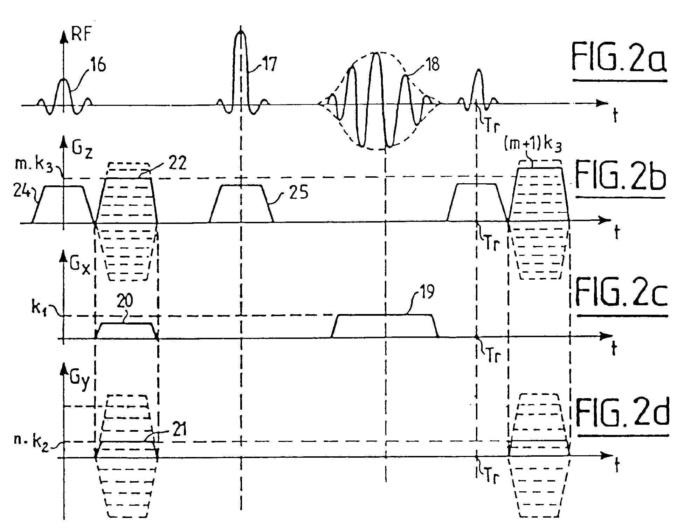

Les figures 2a à 2d montrent l'allure du signal radiofréquence et l'allure des impulsions de gradient de champ selon chacun des axes ZXY respectivement au cours d'une séquence d'excitation-mesure utilisée dans l'invention. Au cours d'une telle séquence une excitation radiofréquence 16 a pour effet de faire basculer l'orientation des moments magnétiques des particules du corps. Eventuellement, une impulsion radiofréquence dite d'écho de spin 17 est également appliquée pour faire renaître, en 18, le signal de RMN du corps. A l'issue d'une durée Tr, une séquence suivante est entreprise. Dans l'invention les séquences sont groupées en macro-séquences et l'ensemble des macro-séquences constitue l'ensemble des séquences de l'expérimentation.

Une macro-séquence comporte un nombre réduit M de séquences identiques dans tous leurs éléments sauf pour la valeur d'un gradient de codage de sélection $G_z$. En effet d'une séquence à l'autre sur un axe de lecture X le gradient de lecture $G_x$ est maintenu identique : il est constitué par une impulsion 19 de codage de lecture et par une impulsion 20 de précodage de lecture. Dans toute l'expérimentation ce gradient est constant. Au cours de toutes les séquences d'une macro-séquence le gradient $G_y$ de codage de phase conserve une même valeur $n.k_2$. Cette macro-séquence est appelée la macro-séquence de rang $\underline{n}$. Dans l'expérimentation il y a N macro-séquence (typiquement N vaut 256), et $\underline{n}$ vaut de - N/2 à + N/2 (En toute rigueur $\underline{n}$ ne devrait prendre des valeurs qu'entre -N/2 et N/2-1. Pour simplifier la présentation le -1 a été omis. Il en va de même, par ailleurs, pour M et P. P représente la résolution des images à obtenir développées selon l'axe X. Par contre au cours de la macro-séquence, à chacune des séquences l'impulsion 22 d'un gradient de codage de sélection évolue d'une valeur $m\, k_3$ à une valeur suivante $(m+1).\, k_3$. Dans une macro-séquence il y a M séquences (typiquement M vaut 8) et $\underline{m}$ peut prendre les valeurs de -M/2 à + M/2.

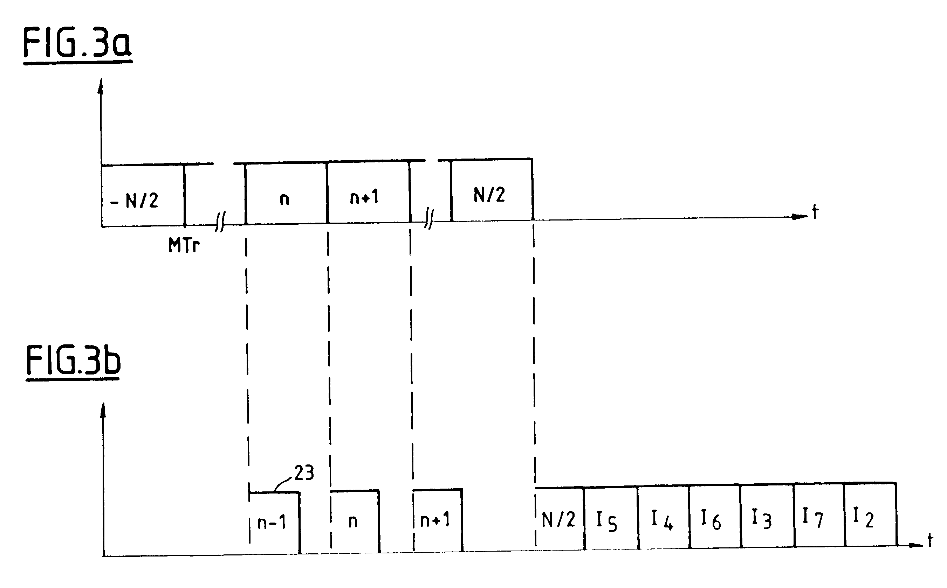

Les figures 3a et 3b montrent le déroulement de l'ensemble des séquences d'imagerie selon l'invention. Il y a N macro-séquences dont la durée élémentaire est à chaque fois M. Tr. Tr est la durée d'une séquence alimentaire. A l'issue des M séquence d'une macro-séquence un premier calcul de transformée de Fourier bidimensionnelle 23 est entrepris. On montrera plus loin que du tait du nombre de pas de calcul impliqué dans ce calcul de transformée de Fourier bidimensionnelle, celui ci peut être facilement terminé avant la fin de la macro-séquence suivante. En pratique, avec les valeurs données dans l'exemple, et en retenant comme durée Tr une durée de l'ordre de 50 millisecondes, une macro-séquence dure 400 millisecondes (l'ensemble des 256 macro-séquences durant alors de l'ordre de 2 mn), tandis que le calcul, avec la mémoire rapide des processeurs vectoriels utilisés, de la transformée bidimensionnelle dure à chaque fois de l'ordre de 40 millisecondes. Autrement dit pendant que la macro-séquence $\underline{n}$ est acquise le calcul de transformée de Fourier bidimensionnelle sur les résultats de l'acquisition relatif à la macro-séquence n - 1 peut être effectué. Il en résulte d'une part un travail en temps réel effectif, et d'autre part une limitation des contraintes d'adressage : des mêmes adresses de la mémoire rapide pouvant être éventuellement réutilisées au cours du calcul de transformée de Fourier bidimensionnelle dans les macro-séquences.

On va rappeler ci-dessous, avec certaines simplifications mathématiques néanmoins, l'architecture théorique du calcul de reconstruction d'image par acquisition tridimensionnelle par méthode 3DFT, ainsi que la modification qu'il en résulte du fait de l'invention. S'agissant d'une séquence où le gradient de codage de phase vaut $n.k_2$, et où le gradient de codage de sélection vaut $m.k_3$, on peut transformer le signal 18 donné en fonction du temps en une suite d'échantillons, régulièrement espacés dans le temps, et au nombre de P : P représente la résolution des images à obtenir développée selon l'axe X. Dans ces conditions le signal 18 se transforme en un signal $S(p,n.k_2,m.k_3)$.

Le calcul de reconstruction par transformée de Fourier nécessite trois étapes dans son principe. La première étape a pour effet de transformer $S(p,n.k_2,m.k_3)$ en :

$$S_{x0}\,(n.k_2,m.k_3)\ =\ \sum_{p\,=\,-P/2}^{p\,=\,P/2}\ e^{-j.p.\,k_1.\,x_0}\ S\,(p,n.k_2,m.k_3)$$

Les transformées de Fourier sont içi des transformées de Fourier approximées par des sommations discrètes sur les P échantillons. Dans la suite de l'exposé, ainsi que dans les revendications on appelera transformée de Fourier le calcul portant ainsi sur une sommation, donc içi pour une valeur de $x_0$. Chaque transformée de Fourier comporte P points de calcul puisque p varie de - P/2 à +P/2. Dans chaque macro-séquences il y a P x M transformées de Fourier telles que celle-ci, parce qu'il y a P valeurs possibles de $x_0$ et qu'il y a M valeurs de m. A la fin de l'acquisition lorsque N macro-séquences ont été acquises, on a alors effectué N x M x P transformées de Fourier telles que celle-ci à P points de calcul. En fait pendant chaque durée 23 on calcule également la deuxième étape de calcul de transformée de Fourier dans laquelle $S_{x0}$ devient $S_{x0\,z0}$. Ce calcul s'écrit de la façon suivante :

$$S_{x0\,z0}\,(n.k_2) \quad = \quad \sum_{m\,=\,-M/2}^{m\,=\,M/2} e^{-j.m.k_3.\,z_0} \quad S_{x0}\,(n.k_2, m.k_3)$$

Ces dernières transformées de Fourier sont des transformées de Fourier à M points de calcul. Dans l'invention M est notablement inférieur à N ou P : dans l'exemple indiqué M vaut huit. Içi encore il faut faire N x M x P transformées de Fourier monodimensionnelles au total.

En pratique, on ne fait pas deux calculs de transformées de Fourier monodimensionnelles comme indiqué, mais un calcul de transformées de Fourier bidimensionnelle qui comportent chacune M x P points de calcul. Ce nombre M x P de points de calcul est à comparer au nombre N x P de l'état de la technique où les séries de séquences étaient acquises en faisant varier le gradient de codage de phase et en maintenant constant le gradient de codage de sélection. Compte tenu de la faible valeur de M il devient possible de réaliser le calcul des N x M x P transformées de Fourier, bidimensionnelles à M x P points de calcul en utilisant la mémoire rapide des processeurs vectoriels. Un algorithme spécifique peut être utilisé avec succès. C'est ce calcul de transformées de Fourier bidimensionnelles qui est effectué à chaque macro-séquence pendant la durée 23.

Pour achever le calcul de reconstruction d'images, il ne reste plus qu'à calculer $S_{x0\,y0\,z0}$ pour toutes les coordonnées x0, y0, z0 du volume étudié dans le corps avec un calcul de la forme suivante :

$$S_{x0\,y0\,z0} \quad = \quad \sum_{n\,=\,-N/2}^{n\,=\,N/2} e^{-j.n.k_2.y_0} \quad S_{x0\,y0}\,(n.k_2)$$

Dans ce dernier calcul il y a N x M x P transformées de Fourier à N pas de calcul dans chacune.

On remarque cependant que l'invention permet, facilement d'envisager la reconstruction d'images dont la résolution selon un des axes (l'axe de codage de phase), est moins bonne que selon l'axe de lecture. Par exemple si N vaut 128, l'acquisition durera deux fois moins longtemps, et le calcul des troisièmes transformées de Fourier sera plus court. Les calculs qui correspondent à ces troisièmes transformées monodimensionnelles sont cotés par les images $I_2$ à $I_7$ sur la figure 3b. Dans l'invention la durée de calcul d'une image est de l'ordre de 3 secondes (avec une résolution de 256 pas de codage de phase). La reconstruction des 8 images $I_1$ à $I_8$ dure théoriquement 24 secondes.

Le procédé de l'invention présente de nombreux avantages. D'une part la durée globale d'acquisition et de reconstruction est de l'ordre de 2 mn 1/2. D'autre part la première image peut être disponible 4 secondes après la fin de l'acquisition; et non pas 12 minutes après comme dans l'état de la technique cité. En effet, le calcul d'une image, qui est définie par $z_0$, peut être organisé en effectuant le calcul des transformées de Fourier sur toutes les valeurs de $S_{x0z0}\,(n.k_2)$ qui correspondent à un même $z_0$ particulier : par exemple celui de l'image $I_1$. Il suffit d'organiser l'adressage $S_{x0\,z0}$ dans ce but. En outre, par des phénomènes connus de repliement d'image, une partie de l'image $I_1$ se retrouve dans l'image $I_8$ et reciproquement. Ces images interfèrent. Il n'est par conséquent pas utile de les calculer. Dans l'invention on élimine tout simplement le calcul de reconstruction des images dont on sait à priori qu'elles sont inutilisables : on ne calcule ni $I_1$ ni $I_8$. Enfin on remarque que l'invention permet de choisir de faire simplement apparaitre en premier l'image centrale, $I_5$ ou $I_4$, dans la partie du volume étudié dans le patient. En effet l'image centrale est la plus souvent intéressante, notamment lorsque le calage d'exploration de la machine est centrée sur elle. Le calcul de toutes les images permet ensuite, alternativement, de produire toutes les 3 secondes des images situées de part et d'autre de l'image centrale tout en s'en éloignant au fur et à mesure. La figure 3 montre alors une séquence type : $I_5$, $I_4$, $I_6$, $I_3$, $I_7$, $I_2$, les images $I_1$ et $I_8$ n'étant par exemple pas calculées.

Pour résoudre les phénomènes de repliements d'image on prend aussi dans l'invention la précaution d'appliquer l'excitation 16, ainsi qu'éventuellement l'excitation d'écho de spin 17, en même temps que des impulsions 24,25 de sélection, de type classique en méthode 2DFT, mais içi à largeur d'exploration plus grande pour restreindre l'excitation du phénomène de résonance au volume où il est prévu de réaliser les images $I_1$ à $I_8$ (figure 2b). En définitive les impulsions de sélection 24 et 25 ont pour objet de sélectionner la macrocoupe dans laquelle toutes les images sont réalisées.

# EP 0 298 849 B1

## Revendications

1. Procédé de reconstruction dont les données d'images sont acquises à partir d'une expérimentation de RMN, procédé du type 3DFT pour lequel on s'impose que la résolution de M points de l'image selon un (Z) des axes de l'image soit inférieure aux résolutions de N et P points de l'image selon les deux autres axes (Y,X) de cette image, ledit procédé comportant dans l'ordre, à partir des données d'image, un premier calcul de N x M x P transformées de Fourier à P points de calcul, suivi d'un deuxième calcul de N x M x P transformées de Fourier à M points de calcul, et suivi d'un troisième calcul de N x M x P transformées de Fourier à N points de calcul, l'image reconstruite se déduisant du résultat du troisième calcul.

2. Procédé selon la revendication 1, selon lequel les deux premiers calcul de transformées de Fourier sont groupés en un quatrième calcul de N x M x P transformées de Fourier bidimensionnelles à M x P points de calcul.

3. Utilisation du procédé selon la revendication 1 ou la revendication 2 et selon lequel l'acquisition est faite par expérimentation de RMN sur un corps (2) à étudier et comporte l'exécution de N macro-séquences comportant chacune M séquences d'excitation-mesure du signal de RMN du corps, et en ce qu'à chaque séquence on mesure P échantillons de ce signal de RMN.

4. Procédé selon la revendication 3 selon lequel les N x M x P transformées de Fourier bidimensionnelles sont chacune calculée à l'issue d'une macro-séquence, qui les caractérise.

5. Procédé selon l'une quelconque des revendications 1 à 4 selon lequel le troisième calcul est arrangé pour produire d'abord une image centrale, cette image centrale étant définie par rapport à l'exploration selon un axe correspondant à la résolution la plus faible.

## Patentansprüche

1. Rekonstruktionsverfahren, für das die Bilddaten mittels eines NMR-Experiments erfaßt werden, wobei das Verfahren vom 3DFT-Typ ist, für das festgelegt wird, daß die Auflösung von M Punkten des Bildes in Richtung einer (Z) der Bildachsen kleiner als die Auflösungen von N und P Punkten des Bildes in Richtung der zwei anderen Achsen (Y, X) dieses Bildes ist, wobei das Verfahren in dieser Reihenfolge, ausgehend von den Bilddaten, umfaßt: eine erste Berechnung von N · M · P Fourier-Transformierten mit P Berechnungspunkten, gefolgt von einer zweiten Berechnung von N · M · P Fourier- Transformierten mit M Berechnungspunkten, gefolgt von einer dritten Berechnung von N · M · P Fourier-Transformierten mit N Berechnungspunkten, wobei das rekonstruierte Bild aus dem Ergebnis der dritten Berechnung abgeleitet wird.

2. Verfahren gemäß Anspruch 1, in dem die zwei ersten Berechnungen der Fourier-Transformierten in einer vierten Berechnung in N · M · P zweidimensionale Fourier- Transformierte mit M · P Berechnungspunkten gruppiert werden.

3. Anwendung des Verfahrens gemäß Anspruch 1 oder Anspruch 2, in dem die Erfassung durch ein NMR-Experiment an einem zu untersuchenden Körper (2) ausgeführt wird, wobei die Erfassung die Ausführung von N Makrofolgen enthält, von denen jede M Folgen von Meßerregungen des NMR-Signals des Körpers enthält, und daß bei jeder Folge P Abtastwerte dieses NMR- Signals gemessen werden.

4. Verfahren gemäß Anspruch 3, in dem die N · M · P zweidimensionalen Fourier-Transformierten jeweils bei Ausgabe einer sie charakterisierenden Makrofolge berechnet werden.

5. Verfahren gemäß einem der Ansprüche 1 bis 4, in dem die dritte Berechnung so beschaffen ist, daß zuerst ein mittiges Bild erzeugt wird, wobei dieses mittige Bild in bezug auf die Untersuchung längs einer der geringsten Auflösung entsprechenden Achse definiert ist.

## Claims

1. A method of reconstructing whose image data are acquired in an NMR investigation, said method being of the 3DFT type for which the condition is accepted that the resolution of M image points along one (Z) of the image axes is less than the resolutions of N and P points of the image along the two other axes (Y and X) of the said image, the said method comprising in the following order, starting with the image data, a first calculation of N x M x P Fourier transforms with P calculation points, followed by a second calculation of N x M x P Fourier transforms with M calculation points, followed by a third calculation of N x M x P Fourier transforms with P calculation points, the reconstructed image being deduced from the result of the third calculation.

2. The method as claimed in claim 1, in accordance with which the two first calculations of the Fourier transforms are grouped in a further calculation of N x M x P bidimensional Fourier transforms with M x P calculation

6

points.

3. The use of the method as claimed in claim 1 or in claim 2 and in accordance with which the acquisition is performed by NMR investigation of a body (2) to be studied and comprises the performance of N macro-sequences of excitation and measurement of the NMR signal of the body and in that during each sequence a measurement of P samples of the said NMR signal is performed.

4. The method as claimed in claim 3, in accordance with which the said N x M x P bidimensional Fourier transforms are each calculated as the issue of a macro-sequence which characterizes the same.

5. The method as claimed in any one of the preceding claims 1 through 4, in accordance with which the third calculation is arranged to produce firstly a central image, said central image being defined in relation to an exploration along an axis corresponding to the resolution which is weakest.

FIG. 1

Bo

1

y
x
z

7
8
6
2
10
3
5
I1 I2 I3 I4 I5 I6 I7 I8
4
13
12

9 — GENERATEUR

GENERATEUR GRADIENT — 14

RECEPTION TRAITEMENT — 11

15 — SEQUENCEUR

EP 0 298 849 B1

FIG.2a

FIG.2b

FIG.2c

FIG.2d

FIG.3a

| − N/2 | | n | n+1 | | N/2 |
|---|---|---|---|---|---|

MTr

FIG.3b

| n−1 | n | n+1 | | N/2 | I5 | I4 | I6 | I3 | I7 | I2 |
|---|---|---|---|---|---|---|---|---|---|---|

23